# EUROPÄISCHE PATENTSCHRIFT

(11) **EP 2 980 660 B1**
(45) Veröffentlichungstag und Bekanntmachung des Hinweises auf die Patenterteilung: **23.11.2016**
(21) Anmeldenummer: 14178797.8
(22) Anmeldetag: 28.07.2014
(51) Int. Cl.: G05B 9/02, G05B 15/02, G01R 31/02, G05B 23/02

(54) **Verfahren und Vorrichtung zum Überwachen und Schalten eines Lastkreises**
Method and device for monitoring and switching a load circuit
Procédé et dispositif de surveillance et de commutation d'un circuit de charge

(43) Veröffentlichungstag der Anmeldung: 03.02.2016
(73) Patentinhaber: Pepperl & Fuchs GmbH, 68307 Mannheim (DE)
(72) Erfinder: Oestreicher, Michael, 68307 Mannheim (DE)
(74) Vertreter: Schiffer, Axel Martin

(56) Entgegenhaltungen:
- DE-A1- 4 441 581
- DE-A1- 10 327 959

## Beschreibung

Die vorliegende Erfindung bezieht sich auf eine Vorrichtung und ein Verfahren zum Überwachen und Schalten eines Lastkreises, also eines Stromkreises aus einer Lastkreisversorgung und einer Last, wobei dieser Stromkreis durch einen Lastschalter geschaltet, insbesondere geschlossen oder unterbrochen werden kann.

Im Bereich der Prozessautomatisierung werden Sensoren und/oder Aktoren (oder Aktuatoren, Effektoren, etc.), also Wandler (oder Antriebselemente, Stellglieder), die zumeist in Form elektrischer Signale vorliegende Befehle einer Steuerung (z.B. eines Steuerungscomputers) in Kräfte, Bewegungen oder andere physikalische Wirkungen (wie z.B. eine Druck- oder Temperaturänderung) umwandeln, häufig über Punkt-zu-Punkt-Verbindungen durch Steuerungen gesteuert. Zwischen der eigentlichen Steuerung und dem Sensor oder Aktor ist dabei häufig ein Schnittstellenbaustein (Interface) angeordnet, der die elektrischen Eigenschaften der von der Steuerung ausgesandten Signale an die durch die Bau- und Funktionsweise der Sensoren oder Aktoren bedingten Eigenschaften der von diesen Sensoren oder Aktoren zu empfangenen Signale anpasst. Die Steuerung befindet sich in diesen Fällen auf der Steuerungsseite des Schnittstellenbausteins, wogegen die der Steuerung abgewandte Seite des Schnittstellenbausteins die Feldseite genannt wird.

Unter dem Begriff Leitungsfehlertransparenz versteht man eine Funktion solcher Systeme, die dafür sorgt, dass ein Fehler, beispielsweise ein Leitungsbruch oder ein Kurzschluss, in der Verkabelung auf der Feldseite eines Schnittstellenbausteins auf dessen Steuerungsseite übertragen wird, so dass die Steuerung den Fehler erkennen kann, und wobei der Fehler sich auf der Steuerungsseite im Idealfall in derselben Weise für die Steuerung bemerkbar macht, wie wenn dieser auf der Feldseite aufgetretene Fehler auf der Steuerungsseite des Schnittstellenbausteins vorläge.

Eine Reihe von üblichen Steuerungen bietet nämlich die Möglichkeit, Fehler wie Leitungsbrüche oder Kurzschlüsse in der Verkabelung von direkt an die Steuerung angeschlossenen Feldgeräten zu erkennen.

Wird nun zwischen die Steuerung und ein Feldgerät ein Schnittstellenbaustein geschaltet, dann kann die Steuerung nur Fehler in der Kabelverbindung auf der Steuerungsseite des Schnittstellenbausteins erkennen, nicht jedoch Fehler auf der Feldseite des Schnittstellenbausteins. Dies ist insbesondere in den Fällen besonders problematisch, in denen der Schnittstellenbaustein in der Nähe der Steuerung angeordnet ist, weil dann die verhältnismäßig lange Kabelstrecke zwischen dem Schnittstellenbaustein und dem Feldgerät unüberwacht bleibt.

DE 10327959 beschreibt ein Verfahren zur Überwachung eines Lastkreises.

Eine Aufgabe der vorliegenden Erfindung kann daher darin gesehen werden, eine Vorrichtung und ein Verfahren anzugeben, mit denen die oben genannten Nachteile vermieden werden.

Diese Aufgabe wird durch eine Vorrichtung nach Anspruch 1 und durch ein Verfahren nach dem unabhängigen Verfahrensanspruch 14 gelöst.

Bevorzugte Ausführungsbeispiele der vorliegenden Erfindung bilden den Gegenstand der abhängigen Ansprüche.

Erfindungsgemäß ist eine Vorrichtung zum Überwachen und Schalten eines Lastkreises vorgesehen, mit einem Eingangsteil und einem Ausgangsteil, mit Schalteingängen zum Anschließen einer Steuerung am Eingangsteil, mit Schaltausgängen zum Anschließen mindestens eines Lastkreises mit mindestens einer zu schaltenden Last am Ausgangsteil, und mit mindestens einem Lastschalter zum Schalten, insbesondere zum Ein- und Ausschalten, der mindestens einen Last. Das Eingangsteil weist eine Eingangsschaltung auf, die über die Schalteingänge eingehende Schaltbefehle der Steuerung in Schaltvorgänge der Lastschalter umsetzt. Die erfindungsgemäße Vorrichtung weist außerdem mindestens eine Fehlerdetektionsschaltung zur Detektion eines Fehlers im Lastkreis und zur Erzeugung mindestens eines ersten Fehlersignals im Ausgangsteil und eine galvanischen Trennstufe zur galvanisch getrennten Übertragung dieses ersten Fehlersignals und/oder eines aus diesem ersten Fehlersignal abgeleiteten zweiten Fehlersignals von dem Ausgangsteil auf das Eingangsteil auf, wobei das übertragene Fehlersignal über die Schalteingänge zur Auswertung zur Verfügung gestellt wird.

Die erfindungsgemäße Vorrichtung zum Überwachen und Schalten eines Lastkreises oder eine ihrer bevorzugten Ausführungsformen wird vorzugsweise als Schnittstellenbaustein zwischen eine Steuerung und ein zu steuerndes Gerät auf der Feldseite, also insbesondere einen Sensor oder einen Aktor, geschaltet oder ist ein Bestandteil eines solchen Schnittstellenbausteins. In diesem Sinne ist im Folgenden auch von einem erfindungsgemäßen Schnittstellenbaustein die Rede.

Im vorliegenden Zusammenhang ist unter einem Lastkreis ein Stromkreis aus einer, nicht notwendigerweise ohmschen, Last und einer Lastkreisversorgung, also einer elektrischen Energiequelle, zu verstehen, die in dem Lastkreis durch die Last einen Strom, insbesondere einen Gleichstrom oder einen Wechselstrom, fließen lässt. Der Lastkreis ist ein Stromkreis in einem zu steuernden Gerät auf der Feldseite der Vorrichtung, also insbesondere in einem Sensor oder in einem Aktor.

Im vorliegenden Zusammenhang ist unter einer Last ein beliebiger allgemeiner, insbesondere nicht-ohmscher, elektrischer Verbraucher zu verstehen.

Im vorliegenden Zusammenhang ist unter einem Lastschalter eine Einrichtung zum Schalten einer Last oder eines Stroms in einem Lastkreis, insbesondere zum Ein- und Ausschalten einer Last oder eines Stroms in einem Lastkreis zu verstehen.

Im vorliegenden Zusammenhang ist unter einer Vorrichtung zum Überwachen eines Lastkreises eine elektronische oder elektrische Schaltung zu verstehen, die bewirkt, dass ein Fehler, insbesondere ein Leitungsbruch oder ein Kurzschluss, im zu überwachenden Lastkreis auf der Feldseite der Vorrichtung sich als vorzugsweise gleichartiger Fehler, also insbesondere als ein Leitungsbruch oder ein Kurzschluss, auf der Steuerungsseite der Vorrichtung für die Steuerung bemerkbar macht.

Im vorliegenden Zusammenhang ist unter einem Eingangsteil einer erfindungsgemäßen Vorrichtung, insbesondere eines erfindungsgemäßen Schnittstellenbausteins, eine Teilvorrichtung, insbesondere eine Teilschaltung, zu verstehen, an die eine Steuerung über Schalteingänge angeschlossen ist oder werden kann. Das Eingangsteil empfängt über die Schalteingänge Schaltbefehle der Steuerung, empfängt ein Fehlersignal von einem Ausgangsteil der erfindungsgemäßen Vorrichtung und stellt das empfangene Fehlersignal der Steuerung über die Schalteingänge zur Auswertung zur Verfügung. Vorzugsweise geschieht dies in Form eines schaltbaren Ruhestroms im Eingangsteil, der in Abhängigkeit von dem empfangenen Fehlersignal geschaltet wird.

Im vorliegenden Zusammenhang ist unter einem Ausgangsteil einer erfindungsgemäßen Vorrichtung, insbesondere eines erfindungsgemäßen Schnittstellenbausteins, eine Teilvorrichtung, insbesondere eine Teilschaltung, zu verstehen, an die mindestens ein Lastkreis mindestens eines zu steuernden Gerätes mit mindestens einer Last über Schaltausgänge angeschlossen ist oder werden kann. Das Ausgangsteil weist wenigstens einen Lastschalter zum Schalten der wenigstens einen Last auf, die vorzugsweise in Wirkverbindung mit einer Eingangsschaltung des Eingangsteils steht, wobei die Eingangsschaltung über die Schalteingänge eingehende Schaltbefehle der Steuerung in Schaltvorgänge der Lastschalter umsetzt.

Im vorliegenden Zusammenhang ist unter einem Schalteingang mindestens ein elektrisch leitender Anschlusskontakt des Eingangsteils einer erfindungsgemäßen Vorrichtung, insbesondere eines erfindungsgemäßen Schnittstellenbausteins, zu verstehen, über den bzw. die das Eingangsteil und somit die Vorrichtung an eine Steuerung angeschlossen ist oder werden kann.

Im vorliegenden Zusammenhang ist unter einem Schaltausgang mindestens ein elektrisch leitender Anschlusskontakt des Ausgangsteils einer erfindungsgemäßen Vorrichtung, insbesondere eines erfindungsgemäßen Schnittstellenbausteins, zu verstehen, über den bzw. die das Ausgangsteil und somit die Vorrichtung an einen Lastkreis angeschlossen ist oder werden kann.

Im vorliegenden Zusammenhang ist unter einer Eingangsschaltung eine Teilschaltung des Eingangsteils einer erfindungsgemäßen Vorrichtung, insbesondere eines erfindungsgemäßen Schnittstellenbausteins, zu verstehen, die über die Schalteingänge eingehende Schaltbefehle der Steuerung in Schaltvorgänge der Lastschalter umsetzt. Vorzugsweise weist eine solche Eingangsschaltung ein Relais zum Schalten wenigstens einen Lastschalters auf.

Im vorliegenden Zusammenhang ist unter einem Schaltbefehl einer Steuerung ein elektrisches Signal, eine Mehrzahl von gleichzeitigen elektrischen Signalen und/oder eine zeitliche Folge von elektrischen Signalen zu verstehen, die von einer Eingangsschaltung über Schalteingänge von der Steuerung empfangen und vorzugsweise mit Hilfe der Ausgangsschaltung in Schaltvorgänge der Lastschalter umgesetzt werden.

Im vorliegenden Zusammenhang ist unter einem, insbesondere ersten, zweiten, abgeleiteten oder übertragenen, Fehlersignal ein elektrisches, insbesondere elektromagnetisches, mechanisches, optisches oder optoelektronisches, Signal oder eine Kombination solcher Signale oder einer zeitlichen Folge solcher Signale zu verstehen, das bzw. die einen Fehler im Lastkreis anzeigen sollen. Unter einem ersten oder zweiten Fehlersignal ist ein derartiges Fehlersignal im Ausgangsteil einer erfindungsgemäßen Vorrichtung, insbesondere eines erfindungsgemäßen Schnittstellenbausteins, zu verstehen. Unter einem übertragenen Fehlersignal ist solch ein Fehlersignal im Eingangsteil einer erfindungsgemäßen Vorrichtung, insbesondere eines erfindungsgemäßen Schnittstellenbausteins, zu verstehen. Unter einem abgeleiteten Fehlersignal ist ein zweites Fehlersignal zu verstehen, das aus einem ersten Fehlersignal durch wenigstens einen Verarbeitungsschritt erzeugt wird oder wurde. Vorzugsweise ist das zweite Fehlersignal über eine galvanische Trennstufe übertragbar, beispielsweise ein pulsierendes oder alternierendes Signal, das aus einem einfachen ersten Fehlersignal, beispielsweise aus einem Gleichstrom, vorzugsweise mittels einer Kippstufe, abgeleitet wird.

Im vorliegenden Zusammenhang ist unter einer Fehlerdetektionsschaltung eine elektrische oder elektronische Schaltung zu verstehen, die elektrisch mit wenigstens einem Lastkreis, vorzugsweise seriell oder parallel, zusammengeschaltet ist und ein Fehlersignal erzeugt, wenn in diesem wenigstens einen Lastkreis ein Fehler auftritt oder vorliegt.

Im vorliegenden Zusammenhang ist unter einer Auswertung eines Fehlersignals eine Verarbeitung dieses Fehlersignals, vorzugsweise durch eine oder die Steuerung, zu verstehen, deren Ergebnis in der Steuerung Einfluss auf die Arbeitsweise der Steuerung im Hinblick auf das Schalten wenigstens einer Last in wenigstens einem durch die Steuerung geschalteten Lastkreis hat.

Im vorliegenden Zusammenhang ist unter einer galvanischen Trennstufe eine Einrichtung zu verstehen, die eine Informationsübertragung zwischen zwei elektrischen Schaltungen ohne eine elektrisch leitfähige Verbindung zwischen diesen beiden elektrischen Schaltungen ermöglicht. Wichtige Beispiele für solche galvanischen Trennungen oder Trennstufen sind induktive Trennstufen in Form von Transformatoren mit elektrisch voneinander getrennten Spulen, vorzugsweise auf einem gemeinsamen Eisenkern, kapazitive Trennstufen, elektromechanische Bauteile wie beispielsweise Relais oder optoelektronische Wandler, insbesondere sogenannte Optokoppler. Unter der galvanisch getrennten Übertragung eines Fehlersignals, insbesondere von dem Ausgangsteil auf das Eingangsteil, ist entsprechend eine Übertragung eines Fehlersignals, insbesondere von dem Ausgangsteil auf das Eingangsteil, ohne eine elektrisch leitfähige Verbindung, insbesondere von dem Ausgangsteil auf das Eingangsteil, zu verstehen.

Im vorliegenden Zusammenhang ist unter einer Kippschaltung eine elektronische oder elektrische Schaltung zu verstehen, die sich alternierend in zwei Zuständen befinden kann, zwischen denen sie, gegebenenfalls aktiviert von einem Steuersignal, selbständig hin- und herschaltet. Solche Schaltungen sind auch als astabile Multivibratoren bekannt.

Im vorliegenden Zusammenhang ist unter einem Ruhestrom bzw. einem Ruhestrompfad ein schaltbarer, auf der Steuerungsseite der erfindungsgemäßen Vorrichtung fließender elektrischer Strom bzw. eine Schaltungsanordnung zur Erzeugung eines schaltbaren Ruhestroms zu verstehen. Das Fließen des Ruhestroms signalisiert der Steuerung vorzugsweise, dass kein Leitungsbruch im Lastkreis vorliegt.

Im vorliegenden Zusammenhang ist unter einem Fehler im Lastkreis insbesondere ein Leitungsbruch oder ein Kurzschluss im Lastkreis zu verstehen.

Bei besonders bevorzugten Varianten der erfindungsgemäßen Vorrichtung und des erfindungsgemäßen Verfahrens ist keine Hilfsenergiequelle zum Versorgen der erfindungsgemäßen Vorrichtung vorhanden. Diese Varianten zeichnen sich demgemäß durch einen geringeren apparativen Aufwand aus. Die erfindungsgemäße Vorrichtung wird dann von der Lastkreisversorgung und/oder von der Steuerseite her mit elektrischer Energie versorgt.

Wird an einer Stelle eines Stromkreises, beispielsweise durch ein defektes Kabel oder durch eine lockere Steckverbindung, die Leitung aufgetrennt, liegt ein Leitungsbruch vor. Dieser verhindert einen Stromfluss in allen Betriebszuständen und ist somit grundsätzlich recht einfach zu erkennen. Bei eingeschalteter Last ist für die Erkennung eines Leitungsbruchs daher die Prüfung des Stromflusses ausreichend. Ist die Last ausgeschaltet, sieht die Erfindung vorzugsweise vor, einen, vorzugsweise niedrigen, Prüfstrom, welcher vorzugsweise konstant und besonders vorzugsweise so niedrig gewählt ist, dass dieser Strom die Last nicht einschalten kann, aus dem Lastkreis zu entnehmen. Wenn dieser Prüfstromstrom unterbrochen wird oder ist, kann auf einen Leitungsbruch geschlossen werden.

Ein Kurzschluss kann, je nach der Stelle, an der er auftritt, unterschiedliche Folgen haben. Dabei kommt es darauf an, ob die Spannungsversorgung der Last durch die erfindungsgemäße Vorrichtung oder durch eine externe Spannungsversorgung realisiert ist. Im ersten Fall, also falls die Spannungsversorgung der Last durch den erfindungsgemäßen Schnittstellenbaustein realisiert ist, gibt es typischerweise nur zwei stromführende Adern zwischen dem Schnittstellenbaustein und der Last. Tritt hier an einer beliebigen Stelle ein Kurzschluss auf, kann dieser durch eine mit dem Kurzschluss einhergehende Verringerung des Widerstandes in dem betroffenen Stromkreis erkannt werden.

Im eingeschalteten Zustand der Last wird der Strom in Folge des Kurzschlusses auf wesentlich höhere Werte ansteigen, als sie im normalen, fehlerfreien Betrieb auftreten. Diese Situation kann durch eine Schaltung erkannt werden, die solche außergewöhnlich hohen Ströme (Überströme) erkennen kann. Im ausgeschalteten Zustand der Last ist die Erkennung eines Kurzschlusses anhand der Spannung möglich, welche der Ruhestrom im Lastkreis erzeugt. Dabei müssen die Leitungswiderstände beachtet werden, welche auch im Kurzschlussfall dafür sorgen können, dass im Lastkreis eine Spannung auftritt. Falls die Ausgangsklemmen des erfindungsgemäßen Schnittstellenbausteins galvanisch von der Feldseite getrennt sind, kann ein Erd- oder Masseschluss gegebenenfalls erst beim Auftreten eins zweiten Fehlers erkannt werden.

Beinhaltet der erfindungsgemäße Schnittstellenbaustein nur Schaltelemente, welche eine externe Spannungsversorgung zu- oder abschalten, dann kann ein Kurzschluss an verschiedenen Stellen auftreten.

Ein Kurzschluss an der Spannungsquelle unterbricht die Lastversorgung und verhindert so einen Stromfluss durch die Last. Dies wirkt auf die meisten Diagnoseschaltungen wie ein Leitungsbruch, obwohl die Verkabelung an keiner Stelle aufgetrennt ist.

Tritt ein Kurzschluss über der Last auf, dann kann dies im ausgeschalteten Zustand nur sehr schwer festgestellt werden, denn die durch den Kurzschluss bewirkte Veränderung des Lastwiderstandes ist auch mit einem Ruhestrom nur schwer messbar, weil die vollständige Spannung an den geöffneten Kontakten des erfindungsgemäßen Schnittstellenbausteins anliegt. Wird der Lastkreis bei vorhandenem Lastkurzschluss eingeschaltet, löst die Sicherung der Spannungsversorgung des Lastkreises (in vielen Fällen, insbesondere bei geeigneter Dimensionierung der Sicherung) aus, wodurch sich ein Leitungsbruch ergibt. Ist dies nicht der Fall, kann der Kurzschluss über einen zu hohen Strom durch die Ausgangsklemmen des erfindungsgemäßen Schnittstellenbausteins detektiert werden.

Bei einem Kurzschluss an den Kontakten des erfindungsgemäßen Schnittstellenbausteins wird die Last ungewollt eingeschaltet. Für den Schnittstellenbaustein selbst geht die Spannung im Lastkreis jedoch auf 0 Volt zurück, was viele übliche Diagnoseschaltungen als Leitungsbruch im Lastkreis deuten.

Hat eine externe Spannungsversorgung der Last Erd- bzw. Massebezug, dann kann ein Erd- bzw. Masseschluss, insbesondere bei Open-Kollektor-Ausgängen zu einem ungewollten Einschalten der Last führen. Dieses Verhalten stellt sich insbesondere dann ein, wenn der Fehler an derjenigen Ader auftritt, welche die Last mit dem Ausgang des erfindungsgemäßen Schnittstellenbausteins verbindet.

Gemäß einer bevorzugten Ausführungsform der vorliegenden Erfindung wird das übertragene erste und/oder zweite Fehlersignal an eine Schaltstufe im Eingangsteil der Vorrichtung übertragen, wobei diese Schaltstufe einen Zustand von mindestens zwei möglichen Zuständen in Abhängigkeit davon einnimmt, ob ein Fehler oder welcher Fehlertyp im Lastkreis detektiert wurde.

Auf diese Weise wird das übertragene Fehlersignal im Eingangsteil in der Form eines stabilen Signals dargestellt, welches von der Steuerung erkannt werden kann.

Im vorliegenden Zusammenhang ist unter einer Schaltstufe eine elektronische oder elektrische Schaltung zu verstehen, die in Abhängigkeit von einem Steuersignal, einen Strom, insbesondere in einem Ruhestrompfad, schaltet, insbesondere ein- oder ausschaltet. Beispiele für Schaltstufen in diesem Sinne sind über einen oder mehrere Transistoren angesteuerte Relais oder Halbleiterschaltungen. Im vorliegenden Zusammenhang ist unter einer geschalteten Schaltstufe eine Schaltstufe im geschalteten Zustand zu verstehen. Entsprechend ist unter einer nicht geschalteten Schaltstufe eine Schaltstufe im nicht geschalteten Zustand zu verstehen.

Gemäß einer weiteren bevorzugten Ausführungsform der vorliegenden Erfindung weist die galvanische Trennstufe mindestens einen Optokoppler auf.

Optokoppler sind optoelektronische Übertrager zwischen zwei galvanisch getrennten Stromkreisen. Sie haben im Vergleich zu anderen galvanischen Trennungen eher geringe Abmessungen, ermöglichen sowohl eine digitale als auch eine analoge Übertragung eines Fehlersignals und weisen keine Induktivitäten auf, die als Quelle von streuenden elektromagnetischen Feldern in Betracht kämen. Auch sind sie unempfindlich gegen störende äußere elektromagnetische Felder und besitzen geringere Verzögerungszeiten und einen geringeren Verschleiß als elektromechanische Lösungen. Im Vergleich zu elektromagnetischen Lösungen zur galvanisch getrennten Übertragung wie Relais oder Transformatoren ist der Ein- und/oder Ausgangskreis solcher optoelektronischen Übertrager jedoch häufig empfindlicher gegenüber einer Überlastung oder gegenüber Störimpulsen.

Gemäß einer weiteren bevorzugten Ausführungsform der vorliegenden Erfindung weist mindestens eine Fehlerdetektionsschaltung eine Stromregelung zum Entnehmen eines Prüfstroms aus dem Lastkreis auf, wobei das erste Fehlersignal unterschiedlich ist, je nachdem, ob der Prüfstrom fließt oder unterbrochen ist. Diese Ausführungsform ermöglicht eine besonders einfache Fehlerdetektion und eine transparente Übermittlung von Fehlerzuständen vom Ausgangsteil auf das Eingangsteil.

Gemäß einer weiteren bevorzugten Ausführungsform der vorliegenden Erfindung ist der Prüfstrom gegenüber einem im Lastfall im Lastkreis fließenden Strom vernachlässigbar klein. Diese Ausführungsform ermöglicht eine Fehlerdetektion mit sehr geringer Störwirkung auf das Geschehen im Lastkreis.

Gemäß einer weiteren bevorzugten Ausführungsform der vorliegenden Erfindung ist der Prüfstrom konstant.

Diese Ausführungsform ermöglicht eine Fehlerdetektion, die besonders robust ist gegenüber Schwankungen der Ströme im Lastkreis.

Gemäß einer weiteren bevorzugten Ausführungsform der vorliegenden Erfindung weist die galvanische Trennstufe mindestens einen Transformator und eine Kippschaltung zum Wandeln des Prüfstroms in einen alternierenden Prüfstrom auf, wobei die Stromregelung und die Kippschaltung eine Serienschaltung bilden, die parallel zu dem Lastschalter geschaltet ist, wobei ein Eingang der galvanischen Trennstufe mit einem Ausgang der Kippschaltung verbunden ist und wobei ein Ausgang der galvanischen Trennstufe über einen ersten Gleichrichter mit einem Eingang der Schaltstufe verbunden ist.

Diese Ausführungsform ermöglicht eine besonders einfache und gleichzeitig wirkungsvolle galvanische Trennung, über die eine Informationsübertragung mit Hilfe zeitlich veränderlicher Ströme auf einfache Weise möglich ist. Der alternierende Prüfstrom ist ein aus dem Prüfstrom abgeleitetes Fehlersignal, das über einen Transformator galvanisch getrennt vom Ausgangsteil auf das Eingangsteil übertragen werden kann.

Gemäß einer weiteren bevorzugten Ausführungsform der vorliegenden Erfindung ist ein zweiter Gleichrichter mit der Stromregelung und der Kippschaltung in Reihe geschaltet.

Der zweite Gleichrichter bewirkt, dass ein im Lastkreis fließender Wechselstrom in dem parallel zum Lastkreis geschalteten Prüfstromkreis gleichgerichtet wird. Auf diese Weise kann die Fehlerdetektionsschaltung unabhängig davon arbeiten, ob im Lastkreis ein Gleichstrom oder ein Wechselstrom fließt.

Falls im Lastkreis nur mit Wechselstrom gerechnet werden muss und ein dem Lastkreis entnommener Prüfstrom daher ohne den zweiten Gleichrichter in jedem Fall ein Wechselstrom wäre, könnte dieser alternierende Prüfstrom ohne eine Kippstufe direkt über den Transformator vom Ausgangsteil auf das Eingangsteil übertragen werden.

Gemäß einer weiteren bevorzugten Ausführungsform der vorliegenden Erfindung weist die galvanische Trennstufe mindestens einen Transformator zum Übertragen eines dem Lastkreis direkt entnommen alternierenden Prüfstroms auf.

Gemäß einer weiteren bevorzugten Ausführungsform der vorliegenden Erfindung schaltet die Schaltstufe einen Ruhestrom in einem Ruhestrompfad im Eingangsteil. Auf diese Weise "sieht" die Steuerung am Eingangsteil der erfindungsgemäßen Vorrichtung einen Zustand, der dem Zustand entspricht, den die Steuerung "sähe", wenn die Steuerung direkt mit dem Lastkreis verbunden wäre. In diesem Sinne liegt hier also ein hohes Maß an Leitungsfehlertranspararenz vor.

Gemäß einer weiteren bevorzugten Ausführungsform der vorliegenden Erfindung hat der Ruhestrom im Wesentlichen gleiche Stärke wie der Prüfstrom. Das Prinzip der Leitungsfehlertransparenz wird durch diese Ausführungsform in noch höherem Maße verwirklicht.

Gemäß einer weiteren bevorzugten Ausführungsform der vorliegenden Erfindung weist der Ruhestrompfad im Eingangsteil eine durch wenigstens einen Transistor gesteuerte Konstantstromquelle auf. Das Ziel der Leitungsfehlertransparenz, insbesondere die Bereitstellung eines definierten Ruhestroms am Eingangsteil der erfindungsgemäßen Vorrichtung, kann mit einer transistorgesteuerten Konstantstromquelle besonders einfach und wirkungsvoll verwirklicht werden.

Gemäß einer weiteren bevorzugten Ausführungsform der vorliegenden Erfindung weist die elektronische Schaltstufe wenigstens einen Feldeffekttransistor auf, dessen Gate-Elektrode mit einer ersten Ausgangsklemme der Gleichrichterschaltung verbunden ist und dessen Drain-Elektrode mit einer zweiten Ausgangsklemme der Gleichrichterschaltung und gleichzeitig über den Ruhestrompfad mit einem Schalteingang verbunden ist. Das Ziel der Leitungsfehlertransparenz, insbesondere die Bereitstellung eines definierten Ruhestroms am Eingangsteil der erfindungsgemäßen Vorrichtung, kann mit einer derartigen Schaltung besonders einfach und wirkungsvoll verwirklicht werden.

Gemäß einer weiteren bevorzugten Ausführungsform der vorliegenden Erfindung weist die Eingangsschaltung eine Spule auf, die mit wenigstens einem Lastschalter in Wirkverbindung steht. Diese bevorzugte Ausführungsform bewirkt eine galvanisch getrennte Übertragung der Schaltbefehle der Steuerung vom Eingangsteil auf das Ausgangsteil und somit die sichere Steuerung auch von Starkstromlasten durch Steuerungen auf der Grundlage üblicher Digitalschaltungen ohne den Einsatz von Leistungshalbleitern.

Ferner ist erfindungsgemäß ein Verfahren zum Überwachen und Schalten eines Lastkreises mit einer Last vorgesehen, bei dem
a) zwischen eine Steuerung und den Lastkreis eine Vorrichtung mit einem Eingangsteil und einem Ausgangsteil geschaltet wird oder ist,
b) das Eingangsteil eine Eingangsschaltung aufweist, die über Schalteingänge eingehende Schaltbefehle der Steuerung in Schaltvorgänge der Lastschalter umsetzt,
c) mindestens eine Fehlerdetektionsschaltung Fehler im Lastkreis detektiert und mindestens ein erstes Fehlersignal im Ausgangsteil erzeugt,
d) eine galvanische Trennstufe dieses erste Fehlersignal und/oder ein aus diesem ersten Fehlersignal abgeleitetes zweites Fehlersignal von dem Ausgangsteil auf das Eingangsteil in galvanisch getrennter Weise überträgt , und bei dem
e) das übertragene Fehlersignal über die Schalteingänge zur Auswertung zur Verfügung gestellt wird.

Gemäß einer bevorzugten Ausführungsform des erfindungsgemäßen Verfahrens ist oder wird zwischen die Steuerung und den Lastkreis eine erfindungsgemäße Vorrichtung, insbesondere nach einer der beschriebenen bevorzugten Ausführungsformen, geschaltet.

Weitere vorteilhafte Ausführungsbeispiele der Erfindung werden nachstehend mit Bezug auf die beigefügten schematischen Figuren erläutert. Hierin zeigen:
- Fig. 1: eine schematische Darstellung einer erfindungsgemäßen Anordnung einer erfindungsgemäßen Vorrichtung zum Überwachen und Schalten eines Lastkreises zwischen einer Steuerung und einem Lastkreis;
- Fig. 2: schematische Darstellungen einer Anordnung eines Schnittstellenbausteins nach dem Stand der Technik zwischen einer Steuerung und Lastkreisen;
- Fig. 3: eine schematische Darstellung eines Ausführungsbeispiels einer erfindungsgemäßen Vorrichtung zum Überwachen und Schalten eines Lastkreises;
- Fig. 4: eine schematische Darstellung einer erfindungsgemäßen Vorrichtung zum Überwachen und Schalten eines Lastkreises, bei der für den Lastkreis eine Hilfsenergiequelle vorhanden ist;
- Fig. 5: eine schematische Darstellung eines weiteren Ausführungsbeispiels einer erfindungsgemäßen Vorrichtung zum Überwachen und Schalten eines Lastkreises;
- Fig. 6: eine schematische Darstellung einer erfindungsgemäßen Vorrichtung zum Überwachen und Schalten eines Lastkreises, bei der für den Lastkreis eine Hilfsenergiequelle vorhanden ist;
- Fig. 7: eine schematische Darstellung eines weiteren Ausführungsbeispiels einer erfindungsgemäßen Vorrichtung zum Überwachen und Schalten eines Lastkreises;
- Fig. 8: eine schematische Darstellung eines weiteren Ausführungsbeispiels einer erfindungsgemäßen Vorrichtung zum Überwachen und Schalten eines Lastkreises;
- Fig. 9: eine schematische Darstellung eines Ausführungsbeispiels einer Konstantstromquelle in einer erfindungsgemäßen Vorrichtung zum Überwachen und Schalten eines Lastkreises;
- Fig. 10: eine schematische Darstellung eines Ausführungsbeispiels einer Konstantstromquelle in einer erfindungsgemäßen Vorrichtung zum Überwachen und Schalten eines Lastkreises;
- Fig. 11: eine schematische Darstellung eines Ausführungsbeispiels einer Überspannungsschutzschaltung in einer erfindungsgemäßen Vorrichtung zum Überwachen und Schalten eines Lastkreises;
- Fig. 12: eine schematische Darstellung eines Ausführungsbeispiels einer Schaltungsanordnung zum Auftrennen des Ruhestrompfades in einer erfindungsgemäßen Vorrichtung zum Überwachen und Schalten eines Lastkreises;
- Fig. 13: eine schematische Darstellung eines Ausführungsbeispiels einer Teilschaltung in einer erfindungsgemäßen Vorrichtung zum Überwachen und Schalten eines Lastkreises;
- Fig. 14: eine schematische Darstellung eines Ausführungsbeispiels einer Teilschaltung in einer erfindungsgemäßen Vorrichtung zum Überwachen und Schalten eines Lastkreises;
- Fig. 15: eine schematische Darstellung eines Ausführungsbeispiels einer Teilschaltung in einer erfindungsgemäßen Vorrichtung zum Überwachen und Schalten eines Lastkreises.

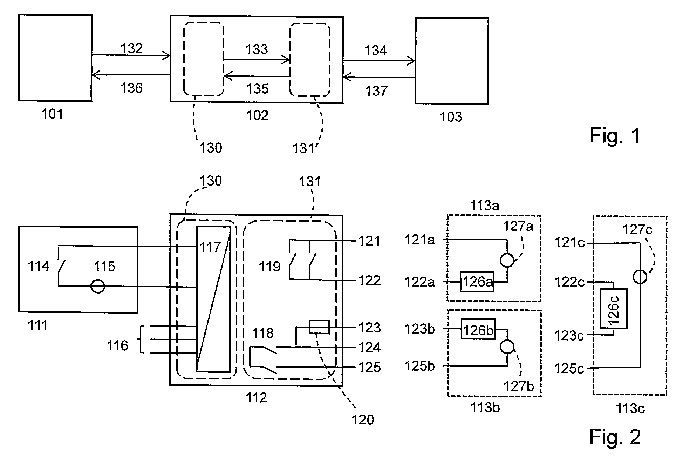

Ein typischer, der vorliegenden Erfindung zugrundeliegender allgemeiner Aufbau einer Anordnung mit einer Steuerung 101, einem Schnittstellenbaustein 102 und einem Lastkreis 103 wird in Fig. 1 gezeigt.

Der Lastkreis ist der Stromkreis eines auf der Feldseite des erfindungsgemäßen Schnittstellenbausteins 102 an den Schnittstellenbaustein 102 angeschlossenen Gerätes 103, wie zum Beispiel eines Aktors oder eines Sensors. In dem Schnittstellenbaustein 102 befindet sich ein Eingangsteil 130 und ein Ausgangsteil 131. Die Steuerung 101 sendet Steuersignale 132 an den erfindungsgemäßen Schnittstellenbaustein, die durch das Eingangsteil 130 empfangen und in Steuersignale 133 des Eingangsteils an das Ausgangsteil 131 umgesetzt werden. Das Ausgangsteil 131 steuert (Pfeil 134) wiederum den Lastkreis 103. Fehler im Lastkreis wirken sich (Pfeil 137) auf die Fehlererkennung im Schnittstellenbaustein aus und werden von Schaltungen zur Fehlererkennung (oder Fehlerdetektion) des Ausgangsteils an das Eingangsteil übergeben (Pfeil 135). Der erfindungsgemäße Schnittstellenbaustein bewirkt auf diese Weise eine Fehlersimulation 136 eines Fehlers im Lastkreis für die Steuerung 101.

Die vorliegende Erfindung ermöglicht dabei eine Leitungsfehlertransparenz in dem Sinn, dass ein Fehler, beispielsweise ein Leitungsbruch oder ein Kurzschluss, in der Verkabelung auf der Feldseite eines erfindungsgemäßen Schnittstellenbausteins auf dessen Steuerungsseite übertragen wird, so dass die Steuerung den Fehler erkennen kann, wobei der Fehler sich auf der Steuerungsseite in ähnlicher oder in derselben Weise für die Steuerung bemerkbar macht, wie wenn dieser auf der Feldseite aufgetretene Fehler auf der Steuerungsseite des erfindungsgemäßen Schnittstellenbausteins vorläge.

Fig. 2 zeigt eine Anordnung nach dem Stand der Technik, mit einem Schnittstellenbaustein 112 nach dem Stand der Technik, dessen Eingangsteil 130 ein oder mehrere, zusammen gesteuerte Relais 117 aufweist, mit dem die Schalter 118 und 119 in dem Ausgangsteil 131 geschaltet werden können. Der Strom durch das Relais 117 stammt aus einer Stromquelle 115 der Steuerung 111, die mit Hilfe eines Schalters 114 der Steuerung geschaltet wird. Das Eingangsteil 130 des Schnittstellenbausteins 112 kann außerdem über Testeingänge 116 verfügen.

In der in Figur 2 dargestellten Anordnung aus dem Stand der Technik sind die Schalter 118 in Reihe geschaltet, wodurch ein sicheres Ausschalten des Lastkreises 113b möglich wird. Der Lastkreis 113b besteht aus der Last 126b und der Lastkreisversorgung 127b und ist über die Kontakte 123b und 125b mit den Ausgangsklemmen 123 und 125 der Ausgangsschaltung 131 verbunden, wobei in dem hier gezeigten Beispiel noch eine Sicherung 120 vorgesehen ist. Die Schalter 119 sind parallel geschaltet, wodurch ein sicheres Einschalten des Lastkreises 113a ermöglicht wird, der aus einer Last 126a und einer Lastversorgung 127a besteht und über die Anschlüsse 121 a und 122a mit den Anschlussklemmen 121 und 122 der Ausgangsschaltung 131 verbunden ist. Der aus der Last 126c und der Lastkreisversorgung 127c bestehende Lastkreis 113c ist über die Anschlüsse 121 c, 122c, 123c und 125c mit den Anschlüssen 121, 122, 123 und 125 des Schnittstellenbausteins 112 verbunden.

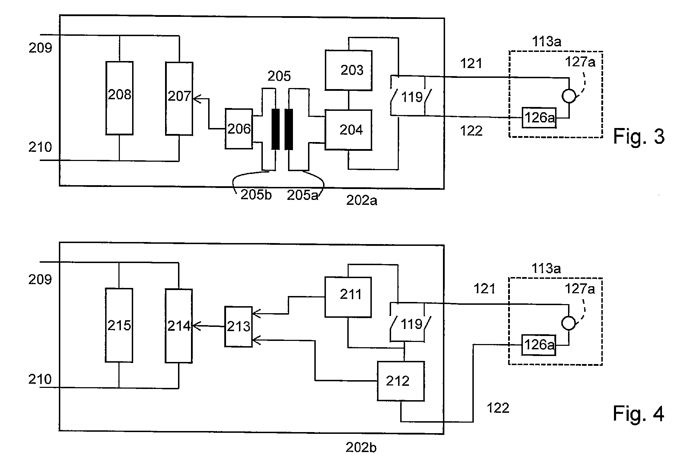

In Fig. 3 ist ein bevorzugtes Ausführungsbeispiel eines erfindungsgemäßen Schnittstellenbausteins 202a dargestellt, der über die Eingangsklemmen 209 und 210 des Schnittstellenbausteins mit der Steuerung verbunden ist und der über die Ausgangsklemmen 121 und 122 des Schnittstellenbausteins mit dem Lastkreis 113a verbunden ist. Die parallel geschalteten Schalter 119 werden vorzugsweise durch ein Relais der Eingangsschaltung 208 geschaltet. Parallel zum Lastkreis ist eine Serienschaltung der Stromregelung 203 mit der Kippstufe 204 angeordnet. Die Kippstufe 204 verwandelt den Konstantstrom der Stromregelung 203 in ein zeitveränderliches Signal, das über den Übertrager 205 auf den Gleichrichter 206 übertragen werden kann. Das Ausgangssignal des Gleichrichters 206 schaltet den schaltbaren Ruhestromzweig 207.

Bei geöffneten Ausgangskontakten 119 wird dem Lastkreis 113a ein vorzugsweise kleiner Strom entnommen. Dies ist nur möglich, wenn die Lastkreisversorgung 127a vorhanden und in Betrieb ist, und wenn die Verkabelung des Lastkreises in Ordnung ist. Das Fließen dieses Stromes ist daher ein Hinweis für die ordnungsgemäße Betriebsbereitschaft des Lastkreises. In diesem Fall wird die Kippstufe 204 dazu veranlasst, ein Wechselstromsignal zu erzeugen, das über den Übertrager 205 auf einen Gleichrichter 206 übertragen wird. Dieser Gleichrichter 206 steuert den eingangsseitigen Ruhestromkreis 207 so an, dass hier ein Ruhestrom nur dann fließt, wenn im Lastkreis 113a ein Ruhestrom fließt. Die galvanische Trennung 205 trennt dabei die Eingangsseite 130 von der Ausgangsseite 131 in galvanischer Weise und ermöglicht hierdurch die Überwachung auch hoher Spannungen im Lastkreis, die für eine direkte Überwachung durch die Steuerung 101 zu groß wären.

Die Fig. 4 zeigt eine weitere Vorrichtung, bei der der erfindungsgemäße Schnittstellenbaustein 202b zwei Fehlerdetektionsschaltungen 211 und 212 aufweist, wobei die Fehlerdetektionsschaltung 211 parallel zum Lastkreis 113a geschaltet ist und wobei die Fehlerdetektionsschaltung 212 seriell in den Lastkreis 113a integriert ist. Durch die Fehlerdetektionsschaltung 212 fließt also nur dann ein Strom, wenn zumindest einer der Schalter 119 geschlossen ist, wogegen an der Fehlerdetektionsschaltung 211 nur dann eine Spannung anliegt, wenn beide Schalter 119 geöffnet sind. Die Verknüpfungsschaltung 213 verknüpft die Ergebnisse der Fehlerdetektionen 211 und 212 und das Verknüpfungsergebnis schaltet die Ruhestromschaltstufe 214, die parallel zur Eingangsschaltung 215 angeordnet ist, welche die Schalter 119 betätigt.

Anstelle einer Kippstufe und eines Übertragers mit nachgeschaltetem Gleichrichter wird das Fehlersignal hier ohne galvanische Trennung über eine Verknüpfungsschaltung, vorzugsweise ein ODER-Gatter, von der Ausgangsseite auf die Eingangsseite übertragen. Die Steuerung des schaltbaren Ruhestromzweigs 207 kann vorzugsweise galvanisch getrennt über ein Relais 309 erfolgen.

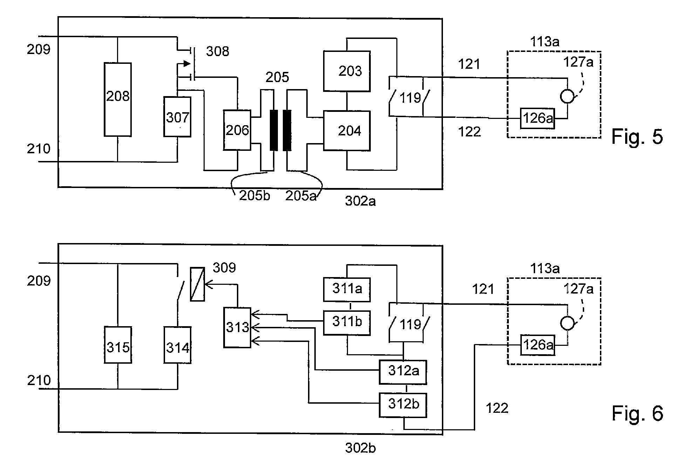

Fig. 5 zeigt eine Konkretisierung der in der Fig. 3 gezeigten Ausführungsform, in der der Ruhestromzweig 207 beziehungsweise 307 durch einen MOSFET 308 geschaltet wird, dessen Gate durch den Ausgang des Gleichrichters 206 gesteuert wird. Die am Gleichrichter 206 ausgangsseitig anliegende Spannung schaltet vorzugsweise den MOSFET 308 leitend, der den Ruhestromkreis 307 am Leben erhält, welcher der Steuerung 101 den Zustand "Lastkreis OK" signalisiert.

Fig. 6 zeigt eine Konkretisierung des in Fig. 4 gezeigten Ausführungsbeispiels, bei dem die Fehlerdetektionsschaltung 211 einen Prüfstromzweig 311 a und eine Schaltung zur Leitungsbrucherkennung 311 b aufweist, und bei dem die Fehlerdetektionsschaltung 212 eine Schaltung zur Leitungsbrucherkennung 312a und eine Schaltung zur Kurzschlusserkennung 312b aufweist. Die Ausgangssignale der Fehlerdetektionsschaltungen 311d, 312a und 312b werden in der Verknüpfungsschaltung 313, beispielsweise einem ODER-Gatter, logisch verknüpft und das Ergebnis dieser Verknüpfung steuert ein Relais 309, welches den Ruhestromzweig 314 schaltet. Das Relais öffnet einen seriellen Kontakt im Eingangskreis, was von der Steuerung detektiert werden kann. Die Eingangsschaltung 315 betätigt die Schalter 119.

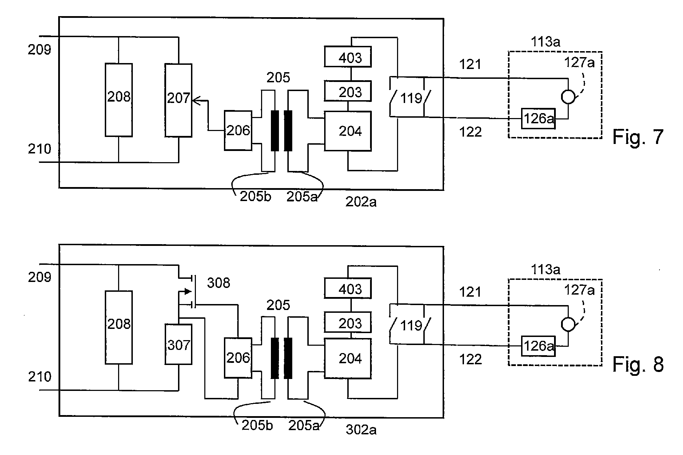

Die Fig. 7 zeigt eine Variante des in Fig. 3 gezeigten Ausführungsbeispiels, bei dem in die Reihenschaltung der Schaltungen 203 und 204 ein Gleichrichter 403 integriert wurde. Mit diesem Ausführungsbeispiel der Erfindung ist wegen des Gleichrichters 403 auch die Detektion von Wechselströmen im Lastkreis 113a möglich.

Die Fig. 8 zeigt eine Variante der Fig. 4, bei der in entsprechender Weise ein Gleichrichter 403 in die Reihenschaltung der Schaltungen 203 und 204 integriert wurde. Mit diesem Ausführungsbeispiel der Erfindung ist wegen des Gleichrichters 403 auch die Detektion von Wechselströmen im Lastkreis 113a möglich.

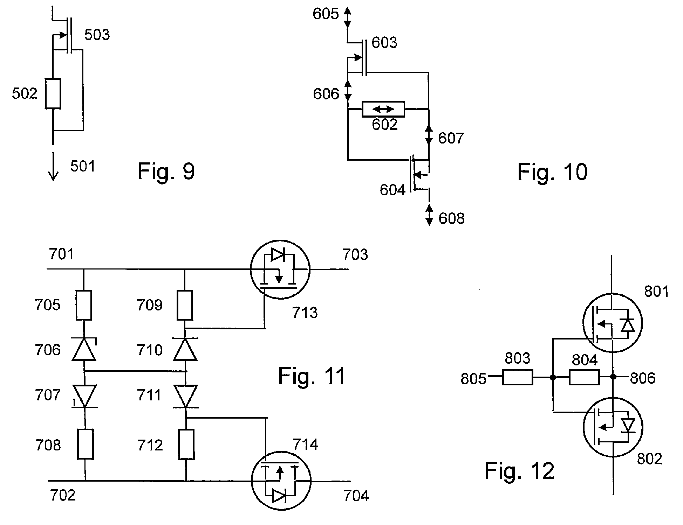

Fig. 9 zeigt eine Stromquellenschaltung, durch die ein Strom 501 fließt, wobei die Stromquellenschaltung aus einem Shunt-Widerstand 502 und einem selbstleitenden MOSFET 503 besteht. Der Spannungsabfall am Shunt-Widerstand 502, der proportional zum Strom 501 ist, erzeugt ein Absinken der Gatespannung des MOSFET 503, wodurch der Strom 501 durch den Shunt-Widerstand 502 begrenzt wird.

Bei Anwendungen mit einem großen Spannungsbereich kommt eine Ruhestromerzeugung durch einen Widerstand allein, wie es bei manchen Steuerungsausgängen üblich ist nicht ernsthaft in Frage, weil bei einem konstanten Widerstandswert der Strom am Ende des Eingangsspannungsbereichs auf ein mehrfaches, z.B. auf das Zehnfache, des Anfangsstroms ansteigen würde. Vorzuziehen ist insbesondere in diesen Fällen deshalb eine Ruhestromerzeugung über eine Konstantstromschaltung, wie sie beispielsweise in der Fig. 9 gezeigt ist. Da der Ruhestromzweig in diesem Fall gleichzeitig die Energieversorgung der Schaltung darstellt, sollte das Schaltungskonzept zur Ruhestromerzeugung keine gesonderte Energieversorgung benötigen.

Ein Vorteil der in Fig. 9 gezeigten Stromquelle ist auch darin zu sehen, dass diese Lösung auch bei großen Spannungsbereichen von beispielsweise 253V Wechselstrom mit Spitzenwerten von bis zu 358V in Frage kommt, wogegen andere Ansätze wie zum Beispiel Konstant-Strom-Dioden oder integrierte Spannungsregler mit einem Shunt-Widerstand nicht verwendet werden sollten. Deshalb wird im Zusammenhang mit der Erfindung eine konstant-Strom-Quelle mit einem selbstleitenden MOSFET mit einem Shunt-Widerstand bevorzugt, wie sie beispielsweise in der Fig. 9 gezeigt ist.

Fig. 10 zeigt eine Variante einer Stromquelle, die polaritätsunabhängig ist und daher unabhängig von einer bestimmten Polarität der Versorgungsspannung betrieben werden kann. Dazu wird die in der Fig. 9 gezeigte Schaltung durch einen zweiten MOSFET erweitert. Die Stromregelung übernimmt dabei immer derjenige der beiden MOSFETs 603 beziehungsweise 604, an dessen Drain-Anschluss das positive Potential anliegt. Wie bei der in Fig. 9 gezeigten Schaltung erzeugt der Strom 605, 608, der durch den Widerstand 602 fließt, eine negative Gate-Source-Spannung, die den Kanal des MOSFET verengt und so den Strom auf einen durch den Widerstand gewählten Wert begrenzt. Weil der zweite MOSFET mit umgekehrter Polarität an diesem Widerstand 602 angeschlossen ist, liegt die über dem Widerstand abfallende Spannung hier als positive Gate-Source-Spannung an, wodurch der Kanal vergrößert wird und so der ungehinderte Durchfluss des Stroms ermöglicht wird.

Falls die Spannung, welche an der in Fig. 10 gezeigten Schaltung anliegt, nicht größer ist als 26,5V, kann mit einem N-Kanal MOSFET vom Verarmungstyp wie beispielsweise mit dem Transistor BSS139 ein günstiger und platzsparender MOSFET verwendet werden. Dieser kann eine maximale Drain-Source-Spannung von 250V aufweisen und einen Strom von 30mA bei einer Gate-Source-Spannung von 0V ermöglichen. Die Gate-Schwell-Spannung liegt mit einem typischen Wert von -1,4V und Abweichungen von -1V bis -2,1V im selben Bereich wie beispielsweise bei dem Transistor BSP135. Mit einem Widerstandswert von 390 Ohm wird in der in Fig. 10 gezeigten Schaltung als Ruhestrom auf der Steuerungsseite ein Strom von ca. 2mA erzeugt, womit alle Ausgangskarten, an denen der erfindungsgemäße Schnittstellenbaustein eingesetzt werden soll, zurechtkommen sollten.

Fig. 11 zeigt eine Teilschaltung einer Ausführungsform eines erfindungsgemäßen Schnittstellenbausteins, mit der der Schaltzustand des Steuerungsausgangs erkannt werden kann. Vorzugsweise sollte die Spannung am Steuerungsausgang für ein 0-Signal unter 3V DC und für ein 1-Signal über 20V DC liegen. Diese Schaltung muss also sicherstellen, dass der Eingang des erfindungsgemäßen Schnittstellenbausteins bei Spannungen unter 3V sicher abgetrennt und bei Spannungen über 20V sicher zugeschaltet ist. Die Polarität der Eingangsspannung darf hierbei, wie auch beim Eingang des Schnittstellenbausteins, keine Rolle spielen.

Um den polaritätsabhängigen Einsatz zu ermöglichen, besteht die Schaltung aus zwei spiegelsymmetrisch identischen Teilen, welche jeweils in einer der beiden Adern, die den Steuerungsausgang mit dem Eingang des Relaisbausteins verbinden, untergebracht sind. Dabei schaltet der MOSFET 703, 704 in dem Zweig mit dem negativen Potential den Eingang des erfindungsgemäßen Schnittstellenbausteins zu und ab. Der andere MOSFET 703, 704 in dem Zweig mit dem positiven Potential wird durch die integrierte Diode überbrückt. Die Schaltschwelle, bei der ein- beziehungsweise ausgeschaltet wird, ergibt sich durch einen Spannungsteiler aus zwei Widerständen 705, 708 und zwei Z-Dioden (Zener-Dioden) 706 und 707. Dabei wird diejenige Z-Diode, welche näher an der Ader mit dem positiven Potential liegt, in Z-Richtung und die zweite Diode in Durchlassrichtung betrieben. Sobald die Eingangsspannung die Summe aus Z-Spannung plus Vorwärtsspannung übersteigt, teilt sich die restliche Spannung im gleichen Verhältnis an den beiden Widerständen auf.

Die Gate-Anschlüsse der beiden MOSFETs sind mit der Mitte des Spannungsteilers verbunden, wobei die jeweils vorgeschaltete Diode dafür sorgt, dass der MOSFET im negativen Zweig nicht durch den zwischen Gate und Source befindlichen Widerstand des anderen MOSFET aktiviert werden kann. Die Gate-Source-Spannung des im negativen Zweig befindlichen MOSFETs entspricht der Spannung, die über einem der beiden Widerstände abfällt, wodurch der MOSFET bei einer ausreichend hohen Eingangsspannung voll durchgeschaltet wird.

Bei der Verwendung von 8,2V-Z-Dioden beträgt diese Spannung ca. 14V und liegt somit genau in dem vorgegebenen Bereich zwischen 3 und 20V. Die dabei am MOSFET anliegende Gate-Source-Spannung liegt bei ca. 2,5V. Bei einer Eingangsspannung von 20V ergibt sich eine rechnerische Gate-Source-Spannung von 5,5V, womit der MOSFET in jedem Fall ausreichend durchgeschaltet werden kann. Die Gate-Source-Spannung des MOSFETs im positiven Zweig ist negativ, wodurch er nicht durchgesteuert werden kann. Da der Strom aber über die in den MOSFET integrierte Diode fließen kann, ist das Durchschalten dieses MOSFETs nicht notwendig. Mit rechnerischen -16,3V bleibt die Spannung hier bei der maximalen Eingangsspannung des erfindungsgemäßen Schnittstellenbausteins ausreichend weit unter der für MOSFETs üblichen maximalen Gate-Source-Spannung von +/-20V.

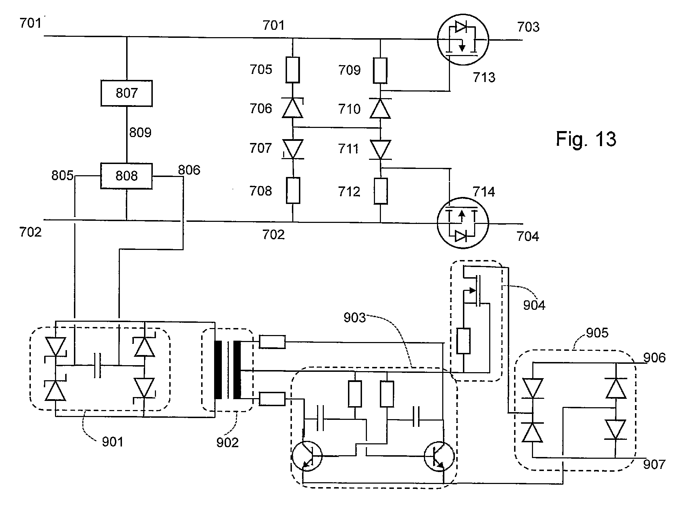

Fig. 12 zeigt eine Teilschaltung zum Auftrennen des Ruhestromzweigs mit zwei antiseriell geschalteten MOSFETs 801 und 802 sowie den Widerständen 803 und 804 an den Anschlusspunkten 805 und 806. Die in der Fig. 12 gezeigte Teilschaltung wird in der Fig. 13 verwendet und ist dort mit dem Bezugszeichen 808 bezeichnet.

Die Fig. 13 zeigt den Schaltplan des erfindungsgemäßen Schnittstellenbausteins in einem Ausführungsbeispiel. Die Anschlussklemmen 805 und 806 der Schaltungsanordnung 808 zur Auftrennung des Ruhestromzweiges sind mit den Ausgängen des Gleichrichters 901 verbunden, welcher das Wechselstromsignal, welches durch den Übertrager 902 übertragen wird, gleichrichtet. Der Gleichrichter 905 entspricht dem Gleichrichter 403 in den Figuren 7 und 8. Die Stromregelung 904 bringt die Kippstufe 903 zum Schwingen, so dass deren Ausgangssignal über den Übertrager 902 übertragen und durch den Gleichrichter 901 gleichgerichtet wird. Im eingangsseitigen Ruhestromzweig 807 des Schnittstellenbausteins fließt deshalb genau dann ein Ruhestrom, wenn auch in dem ausgangsseitigen Ruhestromzweig 904 ein Strom fließt. Unterbrechungen des Stroms im Lastkreis werden daher an die Eingangsseite des Schnittstellenbausteins als Unterbrechungen des Stroms auf der Eingangsseite weitergegeben.

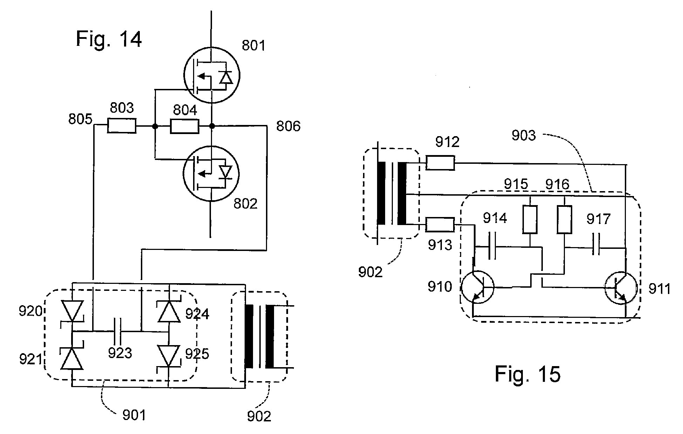

Fig. 14 zeigt eine Teilschaltung der in Fig. 13 gezeigten Gesamtschaltung. Der Gleichrichter 901 besteht in diesem Ausführungsbeispiel aus den Schottky-Dioden 920, 921, 924 und 925 sowie aus der Kapazität 923.

Fig. 15 zeigt als Ausführungsbeispiel eine Teilschaltung der Fig. 13, in der die Kippstufe aus den Bipolartransistoren 910 und 911 sowie aus den Widerständen 912, 913, 915 und 916 sowie aus den Kapazitäten 914 und 917 besteht.

Bei den in den Figuren 3, 5, 7 bis 15 gezeigten Varianten ist keine Hilfsenergiequelle zum Versorgen der erfindungsgemäßen Vorrichtung notwendig.

### Bezugszeichenliste

- 101: Steuerung
- 102: erfindungsgemäßer Schnittstellenbaustein, Vorrichtung zum Überwachen und Schalten eines Lastkreises
- 103: Lastkreis, Feldseitiges Gerät, Aktor, Sensor
- 111: Steuerung
- 112: Schnittstellenbaustein nach dem Stand der Technik
- 113a: Lastkreis
- 113b: Lastkreis
- 113c: Lastkreis
- 114: Schalter
- 115: Stromquelle
- 116: Testeingänge
- 117: Relais
- 118: parallele Schalter
- 119: serielle Schalter
- 120: Sicherung
- 121: Ausgangsklemme des Schnittstellenbausteins
- 122: Ausgangsklemme des Schnittstellenbausteins
- 123: Ausgangsklemme des Schnittstellenbausteins
- 124: Ausgangsklemme des Schnittstellenbausteins
- 125: Ausgangsklemme des Schnittstellenbausteins
- 121a: Eingangsklemme eines Lastkreises
- 121c: Eingangsklemme eines Lastkreises
- 122a: Eingangsklemme eines Lastkreises
- 122c: Eingangsklemme eines Lastkreises
- 123b: Eingangsklemme eines Lastkreises
- 123c: Eingangsklemme eines Lastkreises
- 125b: Eingangsklemme eines Lastkreises
- 125c: Eingangsklemme eines Lastkreises
- 126a: Last
- 126b: Last
- 126c: Last
- 127a: Stromversorgung in einem Lastkreis
- 127b: Stromversorgung in einem Lastkreis
- 127c: Stromversorgung in einem Lastkreis
- 130: Eingangsteil
- 131: Ausgangsteil
- 132: Steuersignale an Schnittstellenbaustein
- 133: Steuerung des Ausgangsteils durch das Eingangsteil
- 134: Steuerung des Lastkreises durch das Ausgangsteil
- 135: Fehlermeldung des Ausgangsteils an das Eingangsteil
- 136: Fehlersimulation des Schnittstellenbausteins für die Steuerung
- 137: Auswirkung eines Lastkreisfehlers auf die Fehlererkennung
- 202a: erfindungsgemäßer Schnittstellenbaustein
- 202b: erfindungsgemäßer Schnittstellenbaustein
- 203: Stromregelung
- 204: Kippstufe
- 205: Übertrager, Transformator, galvanische Trennstufe
- 205a: Primärseitiger Eingang der galvanischen Trennstufe
- 205b: Sekundärseitiger Ausgang der galvanischen Trennstufe
- 206: Gleichrichter
- 207: Schaltbarer Ruhestromzweig
- 208: Eingangsschaltung
- 209: Eingangsklemme des Schnittstellenbausteins
- 210: Eingangsklemme des Schnittstellenbausteins
- 211: Fehlerdetektionsschaltung
- 212: Fehlerdetektionsschaltung
- 213: Verknüpfungsschaltung
- 214: Ruhestromschaltstufe
- 215: Eingangsschaltung
- 302a: erfindungsgemäßer Schnittstellenbaustein
- 302b: erfindungsgemäßer Schnittstellenbaustein
- 307: Ruhestromzweig
- 308: MOSFET
- 309: Relais
- 311a: Prüfstromzweig
- 311b: Leitungsbrucherkennung
- 312a: Leitungsbrucherkennung
- 312b: Kurzschlusserkennung
- 313: Verknüpfungsschaltung, ODER-Gatter
- 314: Relais in Ruhestromschaltstufe
- 315: Eingangsschaltung
- 403: Gleichrichter
- 501: Strom durch Stromquellenschaltung
- 502: Shunt-Widerstand
- 503: Selbstleitender MOSFET
- 602: Widerstand
- 603: Selbstleitender MOSFET
- 604: Selbstleitender MOSFET
- 605: Strom durch Stromquellenschaltung
- 606: Strom durch den Widerstand 602
- 607: Strom durch den Widerstand 602
- 608: Strom durch Stromquellenschaltung
- 701: (Positive) Versorgungsspannung
- 702: (Negative) Versorgungsspannung
- 703: Eingangsklemme des Schnittstellenbausteins
- 704: Eingangsklemme des Schnittstellenbausteins
- 705: Widerstand
- 706: Zenerdiode
- 707: Zenerdiode
- 708: Widerstand
- 709: Widerstand
- 710: Diode
- 711: Diode
- 712: Widerstand
- 713: MOSFET
- 714: MOSFET
- 801: MOSFET
- 802: MOSFET
- 803: Widerstand
- 804: Widerstand
- 805: Schalteingang des Ruhestromzweiges
- 806: Schalteingang des Ruhestromzweiges
- 807: Stromquelle
- 808: Schaltstufe im Ruhestromzweig
- 901: Gleichrichter
- 902: Übertrager, Transformator
- 903: Kippstufe
- 904: Stromquelle
- 905: Gleichrichter
- 906: Anschlussklemme des Gleichrichters in der Fehlererkennung
- 907: Anschlussklemme des Gleichrichters in der Fehlererkennung
- 910: Bipolartransistor in der Kippstufe
- 911: Bipolartransistor in der Kippstufe
- 912: Widerstand
- 913: Widerstand
- 914: Kapazität
- 915: Widerstand
- 916: Widerstand
- 917: Kapazität
- 920: Schottky-Diode
- 921: Schottky-Diode
- 923: Kapazität
- 924: Schottky-Diode
- 925: Schottky-Diode

## Patentansprüche

1. Vorrichtung zum Überwachen und Schalten eines Lastkreises (103)
a) mit einem Eingangsteil (130) und einem Ausgangsteil (131),
b) mit Schalteingängen (209, 210) zum Anschließen einer Steuerung (101) am Eingangsteil (130),
c) mit Schaltausgängen (121, 122) zum Anschließen mindestens eines Lastkreises (103, 113a, 113b, 113c) mit mindestens einer zu schaltenden Last (126a, 126b, 126c) am Ausgangsteil (131),
d) mit mindestens einem Lastschalter (118, 119) zum Schalten, insbesondere zum Ein- und Ausschalten, der mindestens einen Last (126a, 126b, 126c), **dadurch gekennzeichnet dass**:
e) das Eingangsteil (130) eine Eingangsschaltung (208) aufweist, die über die Schalteingänge (209, 210) eingehende Schaltbefehle der Steuerung (101) in Schaltvorgänge der Lastschalter (118, 119) umsetzt,
f) mit mindestens einer Fehlerdetektionsschaltung (211, 212) zur Detektion eines Fehlers im Lastkreis und zur Erzeugung mindestens eines ersten Fehlersignals im Ausgangsteil (131) und
g) mit einer galvanischen Trennstufe (205, 902) zur galvanisch getrennten Übertragung (135) dieses ersten Fehlersignals und/oder eines aus diesem ersten Fehlersignal abgeleiteten zweiten Fehlersignals von dem Ausgangsteil (131) auf das Eingangsteil (130),
h) wobei das übertragene Fehlersignal über die Schalteingänge (209, 210) zur Auswertung zur Verfügung gestellt wird.

2. Vorrichtung nach Anspruch 1,
**dadurch gekennzeichnet,**
**dass** das übertragene erste und/oder zweite Fehlersignal an eine Schaltstufe (207, 214, 808) im Eingangsteil (130) der Vorrichtung übertragen wird, wobei diese Schaltstufe (207, 214, 808) einen Zustand von mindestens zwei möglichen Zuständen in Abhängigkeit davon einnimmt, ob ein Fehler oder welcher Fehlertyp im Lastkreis detektiert wurde.

3. Vorrichtung nach Anspruch 1 oder 2,
**dadurch gekennzeichnet,**
**dass** die galvanische Trennstufe (205, 902) mindestens einen Optokoppler aufweist.

4. Vorrichtung nach einem der vorhergehenden Ansprüche,
**dadurch gekennzeichnet,**
**dass** mindestens eine Fehlerdetektionsschaltung (211) eine Stromregelung (203) zum Entnehmen eines Prüfstroms aus dem Lastkreis (103, 113a), aufweist, wobei das erste Fehlersignal unterschiedlich ist, je nachdem, ob der Prüfstrom fließt oder unterbrochen ist.

5. Vorrichtung nach Anspruch 4,
**dadurch gekennzeichnet,**
**dass** der Prüfstrom gegenüber einem im Lastfall im Lastkreis fließenden Strom vernachlässigbar klein ist.

6. Vorrichtung nach einem der Ansprüche 4 oder 5,
**dadurch gekennzeichnet,**
**dass** der Prüfstrom konstant ist.

7. Vorrichtung nach einem der Ansprüche 4 bis 6,
**dadurch gekennzeichnet, dass**
a) die galvanische Trennstufe (205, 902) mindestens einen Transformator (205, 902) und
b) eine Kippschaltung (204) zum Wandeln des Prüfstroms in einen alternierenden Prüfstrom aufweist, wobei
c) die Stromregelung (203) und die Kippschaltung (204) eine Serienschaltung bilden, die parallel zu dem Lastschalter (119) geschaltet ist,
d) ein Eingang (205a) der galvanischen Trennstufe (205, 902) mit einem Ausgang der Kippschaltung (204) verbunden ist und wobei
e) ein Ausgang (205b) der galvanischen Trennstufe (205, 902) über einen ersten Gleichrichter (206) mit einem Eingang der Schaltstufe (207, 808) verbunden ist.

8. Vorrichtung nach einem der vorhergehenden Ansprüche 4 bis 7,
**dadurch gekennzeichnet,**
**dass** ein zweiter Gleichrichter (403, 905) mit der Stromregelung (203) und der Kippschaltung (204) in Reihe geschaltet ist.

9. Vorrichtung nach einem der vorhergehenden Ansprüche 2 bis 8,
**dadurch gekennzeichnet,**
**dass** die Schaltstufe (207, 208) einen Ruhestrom in einem Ruhestrompfad (307, 314) im Eingangsteil schaltet.

10. Vorrichtung nach einem der Ansprüche 4 bis 9,
**dadurch gekennzeichnet,**
**dass** der Ruhestrom im Wesentlichen gleiche Stärke wie der Prüfstrom hat.

11. Vorrichtung nach Anspruch 9 oder 10,
**dadurch gekennzeichnet,**
**dass** der Ruhestrompfad im Eingangsteil eine durch wenigstens einen Transistor gesteuerte Konstantstromquelle aufweist.

12. Vorrichtung nach einem der Ansprüche 2 bis 11,
**dadurch gekennzeichnet,**
**dass** die elektronische Schaltstufe (207, 808) wenigstens einen Feldeffekttransistor (308, 801, 802) aufweist, dessen Gate-Elektrode mit einer ersten Ausgangsklemme (805) der Gleichrichterschaltung (901) verbunden ist und dessen Drain-Elektrode mit einer zweiten Ausgangsklemme (806) der Gleichrichterschaltung (901) und gleichzeitig über den Ruhestrompfad (307, 807) mit einem Schalteingang (210) verbunden ist.

13. Vorrichtung nach einem der vorhergehenden Ansprüche,
**dadurch gekennzeichnet,**
**dass** die Eingangsschaltung (208) eine Spule (117) aufweist, die mit wenigstens einem Lastschalter (118, 119) in Wirkverbindung steht.

14. Verfahren zum Überwachen und Schalten eines Lastkreises (103) mit einer Last (126a, 126b, 126c), bei dem
a) zwischen eine Steuerung (101) und den Lastkreis (103) eine Vorrichtung mit einem Eingangsteil (130) und einem Ausgangsteil (131) geschaltet wird oder ist,
**dadurch gekennzeichnet dass**:
b) das Eingangsteil (130) eine Eingangsschaltung (208) aufweist, die über Schalteingänge (209, 210) eingehende Schaltbefehle der Steuerung (101) in Schaltvorgänge der Lastschalter (118, 119) umsetzt,
c) mindestens eine Fehlerdetektionsschaltung (211, 212) Fehler im Lastkreis detektiert und mindestens ein erstes Fehlersignal im Ausgangsteil (131) erzeugt,
d) eine galvanische Trennstufe (205, 902) dieses erste Fehlersignal und/oder ein aus diesem ersten Fehlersignal abgeleitetes zweites Fehlersignal von dem Ausgangsteil (131) auf das Eingangsteil (130) in galvanisch getrennter Weise überträgt (135), und bei dem
e) das übertragene Fehlersignal über die Schalteingänge (209, 210) zur Auswertung zur Verfügung gestellt wird.

15. Verfahren nach Anspruch 14, bei dem zwischen die Steuerung (101) und den Lastkreis (103) eine Vorrichtung nach einem der Ansprüche 1 bis 13 geschaltet wird oder ist.

## Claims

1. Device for monitoring and switching a load circuit (103),
a) having an input part (130) and an output part (131),
b) having switching inputs (209, 210) to connect a controller (101) to the input part (130),
c) having switching outputs (121, 122) to connect at least one load circuit (103, 113a, 113b, 113c) with at least one load (126a, 126b, 126c) to be switched to the output part (131),
d) having at least one load switch (118, 119) for switching, in particular for switching on and off, the at least one load (126a, 126b, 126c),
**characterised in that**
e) the input part (130) has an input circuit (208) which converts switching commands of the controller (101) incoming via the switching inputs (209, 210) into switching processes of the load switches (118, 119),
f) at least one fault detection circuit (211, 212) is present to detect a fault in the load circuit and to generate at least a first fault signal in the output part (131) and
g) a galvanic isolation stage (205, 902) is present for galvanically isolated transmission (135) of this first fault signal and / or a second fault signal derived from this first fault signal from the output part (131) to the input part (130),
h) wherein the transmitted fault signal is made available via the switching inputs (209, 210) for evaluation.

2. Device according to claim 1,
**characterised in that**
the transmitted first and / or second fault signal is / are transmitted to a switching stage (207, 214, 808) in the input part (130) of the device, wherein this switching stage (207, 214, 808) assumes one of at least two possible states in dependence upon whether a fault or which fault type has been detected in the load circuit.

3. Device according to claim 1 or 2,
**characterised in that**
the galvanic isolation stage (205, 902) has at least one optocoupler.

4. Device according to one of the preceding claims,
**characterised in that**
at least one fault detection circuit (211) has a current regulator (203) to take a test current from the load circuit (103, 113a), wherein the first fault signal is different depending upon whether the test current flows or is interrupted.

5. Device according to claim 4,
**characterised in that**
the test current is negligibly small in relation to a current flowing in the load circuit in the case of load.

6. Device according to one of claims 4 or 5,
**characterised in that**
the test current is constant.

7. Device according to one of claims 4 to 6,
**characterised in that**
a) the galvanic isolation stage (205, 902) has at least one transformer (205, 902) and
b) a trigger circuit (204) to convert the test current into an alternating test current, wherein
c) the current regulator (203) and the trigger circuit (204) form a series circuit which is connected in parallel with the load switch (119),
d) an input (205a) of the galvanic isolation stage (205, 902) is connected to an output of the trigger circuit (204) and wherein
e) an output (205b) of the galvanic isolation stage (205, 902) is connected via a first rectifier (206) to an input of the switching stage (207, 808).

8. Device according to one of the preceding claims 4 to 7,
**characterised in that**
a second rectifier (403, 905) is connected in series with the current regulator (203) and the trigger circuit (204).

9. Device according to one of the preceding claims 2 to 8,
**characterised in that**
the switching stage (207, 208) switches a no-load current in a no-load current path (307, 314) in the input part.

10. Device according to one of claims 4 to 9,
**characterised in that**
the no-load current has essentially the same strength as the test current.

11. Device according to claim 9 or 10,
**characterised in that**
the no-load current path in the input part has a constant current source controlled by at least one transistor.

12. Device according to one of claims 2 to 11,
**characterised in that**
the electronic switching stage (207, 808) has at least one field effect transistor (308, 801, 802), of which the gate electrode is connected to a first output terminal (805) of the rectifier circuit (901) and of which the drain electrode is connected to a second output terminal (806) of the rectifier circuit (901) and simultaneously via the no-load current path (307, 807) to a switching input (210).

13. Device according to one of the preceding claims,
**characterised in that**
the input circuit (208) has a coil (117) which is in active connection with at least one load switch (118, 119).

14. Method for monitoring and switching a load circuit (103) with a load (126a, 126b, 126c), wherein
a) a device with an input part (130) and an output part (131) is or has been switched between a controller (101) and the load circuit (103),
**characterised in that**
b) the input part (130) has an input circuit (208) which converts switching commands of the controller (101) incoming via switching inputs (209, 210) into switching processes of the load switches (118, 119),
c) at least one fault detection circuit (211, 212) detects faults in the load circuit and generates at least a first fault signal in the output part (131),
d) a galvanic isolation stage (205, 902) transmits this first fault signal and / or a second fault signal derived from this first fault signal from the output part (131) to the input part (130) in a galvanically isolated way (135), and wherein
e) the transmitted fault signal is made available via the switching inputs (209, 210) for evaluation.

15. Method according to claim 14, wherein a device according to one of claims 1 to 13 is or has been switched between the controller (101) and the load circuit (103).

## Revendications

1. Dispositif de surveillance et de commutation d'un circuit de charge (103) :
a) avec un module d'entrée (130) et un module de sortie (131),
b) avec des entrées de commutation (209, 210), pour le raccordement d'un dispositif de commande (101) au niveau du module d'entrée (130),
c) avec des sorties de commutation (121, 122), pour le raccordement, au niveau du module de sortie (131), d'au moins un circuit de charge (103, 113a, 113b, 113c) comportant au moins une charge devant être commutée (126a, 126b, 126c),
d) avec au moins un commutateur de charge (118, 119), pour la commutation - et notamment pour la mise sous tension et hors tension - de la au moins une charge (126a, 126b, 126c),
**caractérisé en ce que :**
e) le module d'entrée (130) comprend un circuit d'entrée (208) qui transforme des commandes de commutation du dispositif de commande (101) entrant par l'intermédiaire des entrées de commutation (209, 210) en des processus de commutation du commutateur de charge (118, 119),
f) avec au moins un circuit de détection de défaut (211, 212), pour la détection d'un défaut dans le circuit de charge et pour la production d'au moins un premier signal de défaut dans le module de sortie (131), et
g) avec un étage de séparation galvanique (205, 902), pour la transmission (135) - galvaniquement isolée - du module de sortie (131) vers le module d'entrée (130) de ce premier signal de défaut et/ou d'un deuxième signal de défaut dérivé de ce premier signal de défaut,
h) le signal de défaut transmis étant mis à disposition pour analyse par l'intermédiaire des entrées de commutation (209, 210).

2. Dispositif selon la revendication 1,
**caractérisé :**
**en ce que** le premier et/ou le deuxième signal de défaut transmis sont transmis à un étage de commutation (207, 214, 808) dans le module d'entrée (130) du dispositif, cet étage de commutation (207, 214, 808) passant alors, en fonction de ces signaux, dans un état parmi au moins deux états possibles, si un défaut ou un quelconque type de défaut est détecté dans le circuit de charge.

3. Dispositif selon la revendication 1 ou 2,
**caractérisé :**
**en ce que** l'étage de séparation galvanique (205, 902) comprend au moins un coupleur optique.

4. Dispositif selon l'une des revendications précédentes,
**caractérisé :**
**en ce qu'**au moins un circuit de détection de défaut (211) comprend une régulation de courant (203) pour l'extraction d'un courant de test à partir du circuit de charge (103, 113a), le premier signal de défaut étant alors, selon le cas, différent selon que le courant de test circule ou qu'il est interrompu.

5. Dispositif selon la revendication 4,
**caractérisé :**
**en ce que** le courant de test est négligeable par rapport à un courant circulant dans le circuit de charge dans le cas d'une charge.

6. Dispositif selon l'une des revendications 4 ou 5,
**caractérisé :**
**en ce que** le courant de test est constant.

7. Dispositif selon l'une des revendications 4 à 6,
**caractérisé en ce que :**
a) l'étage de séparation galvanique (205, 902) comprend au moins un transformateur (205, 902) et
b) une bascule (204) pour la conversion du courant de test en un courant de test alternatif,
c) la régulation de courant (203) et la bascule (204) formant alors un circuit en série qui est connecté en parallèle sur le commutateur de charge (119),
d) une entrée (205a) de l'étage de séparation galvanique (205, 902) est reliée à une sortie de la bascule (204), et
e) une sortie (205b) de l'étage de séparation galvanique (205, 902) est alors reliée, par l'intermédiaire d'un premier redresseur (206), à une entrée de l'étage de commutation (207, 808).

8. Dispositif selon l'une des revendications précédentes 4 à 7, **caractérisé :**
**en ce qu'**un deuxième redresseur (403, 905) est connecté en série à la régulation de courant (203) et à la bascule (204).

9. Dispositif selon l'une des revendications précédentes 2 à 8, **caractérisé :**
**en ce que**, dans le module d'entrée, l'étage de commutation (207, 208) assure la commutation d'un courant de repos dans une voie de courant de repos (307, 314).

10. Dispositif selon l'une des revendications 4 à 9,
**caractérisé :**
**en ce que** le courant de repos a sensiblement la même amplitude que le courant de test.

11. Dispositif selon la revendication 9 ou 10,
**caractérisé :**
**en ce que**, dans le module d'entrée, la voie de courant de repos comprend une source de courant constant commandée par l'intermédiaire d'au moins un transistor.

12. Dispositif selon l'une des revendications 2 à 11,
**caractérisé :**
**en ce que** l'étage de commutation électronique (207, 808) comprend au moins un transistor à effet de champ (308, 801, 802), dont l'électrode de grille est reliée à une première borne de sortie (805) du circuit redresseur (901) et dont l'électrode de drain est reliée à une deuxième borne sortie (806) du circuit redresseur (901) et, en même temps, par l'intermédiaire de la voie de courant de repos (307, 807), à une entrée de commutation (210).

13. Dispositif selon l'une des revendications précédentes,
**caractérisé :**
**en ce que** le circuit d'entrée (208) comprend une inductance (117), qui est reliée, pour former un circuit actif, avec au moins un commutateur de charge (118, 119).

14. Procédé de surveillance et de commutation d'un circuit de charge (103) avec une charge (126a, 126b, 126c), dans lequel :
a) un dispositif comprenant un module d'entrée (130) et un module de sortie (131) est présent ou connecté entre un dispositif de commande (101) et le circuit de charge (103),
**caractérisé en ce que :**
b) le module d'entrée (130) comprend un circuit d'entrée (208) qui transforme des commandes de commutation du dispositif de commande (101) entrant par l'intermédiaire d'entrées de commutation (209, 210) en des processus de commutation du commutateur de charge (118, 119),
c) au moins un circuit de détection de défaut (211, 212) détecte des défauts dans le circuit de charge et produit au moins un premier signal de défaut dans le module de sortie (131),
d) un étage de séparation galvanique (205, 902) transmet (135) de manière galvaniquement isolée ce premier signal de défaut et/ou un deuxième signal de défaut dérivé de ce premier signal de défaut du module de sortie (131) vers le module d'entrée (130), et
e) le signal de défaut transmis est alors mis à disposition pour analyse par l'intermédiaire des entrées de commutation (209, 210).

15. Procédé selon la revendication 14, dans lequel un dispositif selon l'une des revendications 1 à 13 est présent ou raccordé entre le dispositif de commande (101) et le circuit de charge (103).
